# EUROPEAN PATENT APPLICATION

(11) **EP 1 719 822 A1**
(43) Date of publication of application: **08.11.2006**
(21) Application number: 05709335.3
(22) Date of filing: 26.01.2005
(51) Int. Cl.: C23C 14/34, G11B 7/26, G11B 7/24, C04B 35/505, C04B 35/488

(54) **SPUTTERING TARGET, OPTICAL INFORMATION RECORDING MEDIUM AND PROCESS FOR PRODUCING THE SAME**

(30) Priority: 27.02.2004 JP 2004053124
(71) Applicant: Nippon Mining & Metals Co., Ltd., Minato-ku Tokyo 105-0001 (JP)
(72) Inventor: TAKAMI, H., c/o Factory of Nikko Materials Co Ltd, Ibaraki 3191535 (JP); YAHAGI, M., c/o Factory of Nikko Materials Co Ltd, Ibaraki 3191535 (JP)
(74) Representative: Hoarton, Lloyd Douglas Charles
(86) International application number: PCT/JP2005/000966
(87) International publication number: WO 2005/083150

(57) **Abstract**

Provided are a sputtering target comprising a compound oxide of HfO₂ and Y₂O₃; the foregoing sputtering target wherein the Y₂O₃ content is 10 to 95 mol% and the remnant is HfO₂; and the foregoing sputtering target further containing 10 to 90 mol% of ZrO₂. The present invention also provides a thin film for an optical information recording medium (especially used as a protective film) that has stable film amorphous nature, is superior in adhesiveness and mechanical properties with the recording layer, has a high transmission factor, and is composed with a non-sulfide system, whereby the deterioration of the adjacent reflective layer and recording layer can be suppressed. The present invention also provides a manufacturing method of such a thin film, and a sputtering target for use therein. As a result, the present invention is able to improve the performance of the optical information recording medium, and to considerably improve the productivity thereof.

## Description

### TECHNICAL FIELD

The present invention relates to a thin film for an optical information recording medium (especially used as a protective film) that has stable film amorphous nature, is superior in adhesiveness and mechanical properties with the recording layer, has a high transmission factor, and is composed with a non-sulfide system, whereby the deterioration of the adjacent reflective layer and recording layer can be suppressed. The present invention also relates to a manufacturing method of such a thin film, and a sputtering target for use therein.

### BACKGROUND ART

Conventionally, ZnS-SiO₂ generally and primarily used as a protective layer of a phase change optical information recording medium has superior characteristics such as in optical characteristics, heat characteristics, and adhesiveness with the recording layer, and is being widely used.

Nevertheless, rewritable DVDs in the present day as represented by Blu-ray discs are strongly demanded of more write cycles, greater capacity, and faster recording.

As one reason for deterioration in the write cycles of an optical information recording medium, there is the diffusion of a sulfur constituent from the ZnS-SiO₂ to the recording layer material disposed in between the protective layers formed from ZnS-SiO₂.

Further, although pure Ag or Ag alloy having high thermal conduction properties with a high reflection ratio is being used as the reflective layer material for realizing high capacity and high-speed recording, this kind of reflective layer is also disposed to come in contact with the protective layer material of ZnS-SiO₂.

Therefore, in this case also, as a result of diffusion of the sulfur constituent from the ZnS-SiO₂, the pure Ag or Ag alloy reflective layer material is subject to corrosive degradation, and would cause the characteristic degradation in the reflection ratio of the optical information recording medium.

As a measure for preventing the diffusion of such sulfur constituent, attempts have been made to provide an intermediate layer having nitrides or carbides as its primary component between the reflective layer and protective layer, and between the recording layer and protective layer. Nevertheless, this results in an increased number of layers, and there is a problem in that throughput will deteriorate and costs will increase.

In order to overcome the foregoing problems, there is a pressing need to substitute the material with an oxide material that does not contain sulfides in the protective layer material, or discover a material having optical characteristics and amorphous stability that are equivalent to or better than ZnS-SiO₂.

In light of the above, an oxide protective layer material, a transparent conductive material and an optical thin film have been proposed (refer to Patent Documents 1 to 3).

However, Patent Documents 1 to 3 have a problem in that they contain areas that are inferior in optical characteristics and amorphous nature.
[Patent Document 1] Japanese Patent Laid-Open Publication No. H01-317167
[Patent Document 2] Japanese Patent Laid-Open Publication No. 2000-90745
[Patent Document 3] Japanese Patent Laid-Open Publication No. 2003-166052

### SUMMARY OF THE INVENTION

An object of the present invention is to provide a thin film for an optical information recording medium (especially used as a protective film) that has stable film amorphous nature, is superior in adhesiveness and mechanical properties with the recording layer, has a high transmission factor, and is composed with a non-sulfide system, whereby the deterioration of the adjacent reflective layer and recording layer can be suppressed. The present invention also provides a manufacturing method of such a thin film, and a sputtering target for use therein. As a result, the present invention is able to improve the performance of the optical information recording medium, and to considerably improve the productivity thereof.

In order to overcome the foregoing problems, as a result of intense study, the present inventors discovered that, by substituting the conventional protective layer material ZnS-SiO₂ with an oxide material presented below that does not contain sulfides, it is possible to ensure optical characteristics and amorphous stability that are equivalent to ZnS-SiO₂ while improving the characteristics of the optical information recording medium and improving the productivity.

Based on the foregoing discovery, the present invention provides 1) a sputtering target comprising a compound oxide of HfO₂ and Y₂O₃; 2) the sputtering target according to 1) above, wherein the Y₂O₃ content is 10 to 95 mol% and the remnant is HfO₂; and 3) the sputtering target according to 1) or 2) above further containing 10 to 90 mol% of ZrO₂.

Further, the present invention also provides 4) the sputtering target according to any one of 1) to 3) above, wherein the relative density is 90% or higher, 5) an optical information recording medium and a manufacturing method thereof, wherein the sputtering target according to any one of 1) to 4) above is used at least as a thin film in forming a part of an optical information recording medium structure, and 6) an optical information recording medium and a manufacturing method thereof, wherein the sputtering target according to any one of 1) to 5) above is used at least as a thin film in forming a part of an optical information recording medium structure and disposed adjacent to a recording layer or a reflective layer.

### Effect of the Invention

As a result of the above, by substituting the protective layer material ZnS-SiO₂ with an oxide material that does not contain sulfides, it is possible to provide to a thin film for an optical information recording medium (especially used as a protective film) that has superior characteristics such as having stable film amorphous nature, being superior in adhesiveness and mechanical properties with the recording layer, and having a high transmission factor, whereby the deterioration of the adjacent reflective layer and recording layer caused by sulfur can be suppressed, as well as a manufacturing method of such a thin film, and a sputtering target for use therein.

Further, by using this material, a superior effect is yielded in that it is possible to improve the performance of the optical information recording medium, and considerably improve the productivity thereof.

### BEST MODE FOR CARRYING OUT THE INVENTION

The sputtering target of the present invention comprises a compound oxide of HfO₂ and Y₂O₃. In particular, the Y₂O₃ content is 10 to 95 mol% and the remnant is HfO₂. If the Y₂O₃ content is less than 10 mol% or if the Y₂O₃ content exceeds 95 mol%, there is a problem in that the sputtering target will lack stability in the amorphous nature.

Further, 10 to 90 mol% of ZrO₂ may be added. ZrO₂ is characterized in that it has high thermal conductivity. When utilizing this characteristic and adding ZrO₂, it is desirable to added 10 to 90 mol% of ZrO₂. If the ZrO₂ content is less than 10 mol%, there is no effect of addition, and if the ZrO₂ content exceeds 90 mol%, there is a problem in that the sputtering target will lack stability in the amorphous nature, and it is desirable to add ZrO₂ within the range described above.

This material has stable optical characteristics and amorphous nature of the film, and is suitable as a protective layer of a phase-change optical recording medium. Radio frequency sputtering is used for the deposition.

Since this material has stable amorphous nature and is able to improve the transmission factor as described above, it is suitable as a protective layer material for a phase change recording medium or a blue laser phase change recording medium with a fast rewriting speed.

Further, the sputtering target of the present invention is able to achieve a relative density of 90% or higher. The improvement in density yields an effect of improving the uniformity of the sputtered film and inhibiting the generation of particles during sputtering.

The sputtering target described above can be used at least as a thin film in forming a part of an optical information recording medium structure to provide an optical information recording medium. Further, the foregoing sputtering target can be used at least as a thin film in forming a part of an optical information recording medium structure, and disposed adjacent to a recording layer or a reflective layer.

Moreover, the thin film formed using the sputtering target of the present invention forms a part of the optical information recording medium structure and is disposed adjacent to the recording layer or reflective layer, but as described above, since ZnS is not used, there is no contamination by S, there is no diffusion of the sulfur constituent to the recording layer material disposed between the protective layers, and there is a significant effect in that the deterioration of the recording layer can be prevented thereby.

Further, when using pure Ag or Ag alloy having high thermal conduction properties at a high reflection ratio as adjacent reflective layers for realizing high capacity and high-speed recording, diffusion of the sulfur constituent to such adjacent reflective layers will not occur, and a superior effect is yielded in that the cause of the reflective layer material being subject to corrosive degradation and causing characteristic degradation in the reflection ratio of the optical information recording medium can be cleared out.

The sputtering target of the present invention can be manufactured by subjecting the oxide powder of the respective constituent elements, in which the average grain size is 5µm or less, to pressureless sintering or high temperature pressure sintering. It is thereby possible to obtain a sputtering target having a relative density of 90% or higher. In such a case, it is desirable to calcinate the oxide powder having hafnium oxide or yttrium oxide as its primary component at a temperature of 800 to 1400°C before sintering. After this calcination, the resultant powder is pulverized to 3µm or less and used as the raw material for sintering.

Further, by using the sputtering target of the present invention, a significant effect is yielded in that it is possible to improve the productivity, obtain a high-quality material, and stably manufacture an optical recording medium having an optical disk protective film at low costs.

Improvement in the density of the sputtering target of the present invention reduces holes and miniaturizes crystal grains, and enables the sputtered face of the target to become uniform and smooth. As a result, a significant result is yielded in that particles and nodules generated during sputtering can be reduced, the target life can be extended, and the mass productivity can be improved with minimal variation in the quality.

### Examples

Examples and Comparative Examples of the present invention are now explained. These Examples are merely illustrative, and the present invention shall in no way be limited thereby. In other words, the present invention shall only be limited by the scope of the present invention, and shall include the various modifications other than the Examples of this invention.

### (Examples 1 to 6)

Y₂O₃ powder equivalent of 4N and 5µm or less and ZrO₂ powder and HfO₂ powder equivalent of 3N and an average grain size of 5µm or less were prepared, and these powders were mixed to achieve the composition shown in Table 1, subject to wet blending, dried, and thereafter calcinated at 1100°C.

Further, after subjecting the calcinated powder to wet pulverization up to an average grain size equivalent to 1µm, a binder was added and this was granulated with a spray dryer. This granulated powder was subject to cold pressure forming, thereafter subject to pressureless sintering under oxygen atmosphere at 1300 to 1600°C, and this sintered material was formed into a target with machining process. The constituent and composition ratio of this target are shown in Table 1.

**[Table 1]**

| Examples | Composition | Transmission Factor 405nm (%) | Refractive Index 405nm | Amorphous Nature |
|---|---|---|---|---|
| Example 1 | HfO₂-20 mol% Y₂O₃ | 98 | 2.1 | 1.1 |
| Example 2 | HfO₂-40 mol% Y₂O₃ | 96 | 2.1 | 1.0 |
| Example 3 | HfO₂-60 mol% Y₂O₃ | 97 | 2.0 | 1.1 |
| Example 4 | HfO₂-80 mol% Y₂O₃ | 97 | 1.9 | 1.0 |
| Example 5 | ZrO₂-10 mol% HfO₂-20 mol% Y₂O₃ | 97 | 2.1 | 1.1 |
| Example 6 | ZrO₂-30 mol% HfO₂-40 mol% Y₂O₃ | 97 | 2.0 | 1.0 |
| Comparative Example 1 | HfO₂ | 95 | 2.1 | 1.9 |
| Comparative Example 2 | ZrO₂ | 97 | 2.1 | 2.3 |
| Comparative Example 3 | Y₂O₃ | 93 | 1.9 | 2.5 |
| Comparative Example 4 | ZrO₂-5 mol% Y₂O₃ | 97 | 2.0 | 2.1 |
| Comparative Example 5 | HfO₂-5 mol% Y₂O₃ | 95 | 2.1 | 1.8 |
| Comparative Example 6 | ZnS-SiO₂ (20mol%) | 80 | 2.3 | 1.1 |

Amorphous nature was represented with the maximum peak strength against an undeposited glass substrate in a range of 2θ = 20-60° in the XRD measurement of the deposition sample subject to anneal processing (600°C × 30min, Ar atmosphere).

The foregoing 6-inch φ size target subject to finish processing was used to perform sputtering. The sputtering conditions were RF sputtering, sputtering power of 1000W, and Ar gas pressure of 0.5Pa, and deposition was performed at a target film thickness of 1500Å.

Results of the measured transmission factor (wavelength 633nm)%, refractive index (wavelength 633nm), and amorphous nature (represented with the maximum peak strength against an undeposited glass substrate in a range of 2θ = 20-60° in the XRD measurement (Cu-Kα, 40kV, 30mA) of the deposition sample subject to anneal processing (600°C × 30min, Ar atmosphere)) are collectively shown in Table 1.

As a result of the above, the sputtering target of Examples 1 to 6 achieved a relative density of 90% or higher, and stable RF sputtering could be performed.

Further, the transmission factor of the sputtered film achieved 96 to 98% (405µm), the refractive index was 1.9 to 2.1, no specific crystal peak could be observed, and possessed a stable amorphous nature (1.0 to 1.1).

Since the targets of the Examples do not use ZnS, there is no characteristic degradation in the optical information recording medium caused by the diffusion or contamination of sulfur. Further, in comparison to the Comparative Examples described later, the transmission factor, refractive index, and amorphous stability all showed favorable numerical values.

### (Comparative Examples 1 to 6)

As shown in Table 1, materials having components and compositions of raw material powder that are different from the conditions of the present invention were prepared, and, particularly in Comparative Example 6, ZnS raw material powder was prepared, and targets were prepared with these materials under the same conditions as the Examples, and such targets were used to form a sputtered film. The results are similarly shown in Table 1.

With respect to the components and compositions of the Comparative Examples that deviate from the composition ratio of the present invention; for instance regarding Comparative Example 1, since it did not contain any Y oxide, the amorphous nature was 1.9 and showed inferior results.

With Comparative Example 2, since it did not contain any Y oxide as above, the amorphous nature was 2.3 and showed inferior results. With Comparative Example 3, since Y oxide was provided alone, the amorphous nature was 2.5 and showed inferior results.

With Comparative Example 4, since the Y oxide content is less than the reference amount in the combination of Zr oxide and Y oxide, the amorphous nature was 2.1 and showed inferior results.

With Comparative Example 5, since the Y oxide content is less than the reference amount in the combination of Hf oxide and Y oxide, the amorphous nature was 1.8 and showed inferior results.

Further, Comparative Example 6 in particular contained large amounts of ZnS, the transmission factor was 80%, and resulted in a material with risk of being contamination with sulfur.

### INDUSTRIALAPPLICABILITY

Since the thin film formed by using a sputtering target of the present invention forms a part of the structure of the optical information recording medium and does not use ZnS, it yields a significant effect in that diffusion of the sulfur constituent to the recording layer material will not occur, and deterioration of the recording layer can be prevented thereby. Further, when using pure Ag or Ag alloy having high thermal conduction properties at a high reflection ratio as adjacent reflective layers, diffusion of the sulfur constituent to such reflective layers will not occur, and a superior effect is yielded in that the cause of the reflective layer being subject to corrosive degradation and causing characteristic degradation can be cleared out.

Further, in addition to the amorphous nature becoming stabilized, the target will be provided with conductivity, and stable RF sputtering will be enabled by making the relative density a high density of 90% or higher. Moreover, there is a significant effect in that the controllability of sputtering can be facilitated, and the sputtering efficiency can also be improved. Further still, there is significant effect in that it is possible to reduce the particles (dust) or nodules arising during sputtering upon performing deposition, improve the mass productivity with little variation in quality, and stably manufacture an optical recording medium having an optical disk protective film at low costs.

## Claims

1. A sputtering target comprising a compound oxide of HfO₂ and Y₂O₃.

2. The sputtering target according to claim 1, wherein the Y₂O₃ content is 10 to 95 mol% and the remnant is HfO₂.

3. The sputtering target according to claim 1 or claim 2 further containing 10 to 90 mol% of ZrO₂.

4. The sputtering target according to any one of claims 1 to 3, wherein the relative density is 90% or higher.

5. An optical information recording medium and a manufacturing method thereof, wherein the optical information recording medium form a part of an optical information recording medium structure as a thin film by using the sputtering target according to any one of claims 1 to 4.

6. An optical information recording medium and a manufacturing method thereof, wherein the optical information recording medium form a part of an optical information recording medium structure as a thin film by using the sputtering target according to any one of claims 1 to 5 and disposed adjacent to a recording layer or a reflective layer.

## Amended claims

### Amended claims under Art. 19.1 PCT

1. (Amended) A sputtering target for forming an optical information recording medium thin film comprising a compound oxide of HfO₂ and Y₂O₃.

2. (Amended) The sputtering target for forming an optical information recording medium thin film according to claim 1, wherein the Y₂O₃ content is 10 to 95 mol% and the remnant is HfO₂.

3. (Amended) The sputtering target for forming an optical information recording medium thin film according to claim 1 or claim 2 containing 10 to 90 mol% of ZrO₂.

4. (Amended) The sputtering target for forming an optical information recording medium thin film according to any one of claims 1 to 3, wherein the relative density is 90% or higher.

5. (Amended) An optical information recording medium comprising a thin film configured from a compound oxide of HfO₂ and Y₂O₃ formed via sputtering at least at a part of an optical information recording medium structure.

6. (Amended) The optical information recording medium according to claim 5, wherein the Y₂O₃ content is 10 to 95 mol% and the remnant is HfO₂.

7. (Added) The optical information recording medium according to claim 5 or claim 6 containing 10 to 90 mol% of ZrO₂.

8. (Added) The optical information recording medium according to any one of claims 5 to 7, wherein said thin film is disposed adjacent to a recording layer or a reflective layer.

9. (Added) A manufacturing method of an optical information recording medium, wherein a thin film is formed at least at a part of an optical information recording medium structure using the target according to any one of claims 1 to 4.

10. (Added) A manufacturing method of an optical information recording medium according to claim 9, wherein said thin film is disposed adjacent to a recording layer or a reflective layer.

Statement under Art. 19.1 PCT
The invention of claims 1 to 4 has been amended to be a sputtering target for forming an optical information recording medium thin film, and the usage thereof has been clarified.

Further, the invention of claims 5 to 8 has been limited to an optical information recording medium, and the invention of claim 9 and claim 10 has been clarified as a manufacturing method of an optical information recording medium, and the category of the respective inventions has been separated.

Although the present invention and Cited Document 1 (Japanese Patent Laid-Open Publication No. 2003-342721) are similar in that the Y₂O₃ contents coincide at a single point of 10 mol%, Cited Document 1 primarily relates to a material for performing heat-resistance coating treatment to heat-resistant metal of aircraft and gas turbine wings subject to high temperatures.

Meanwhile, the present invention relates to an optical information recording medium, and the object, problems, means for solving the problems and the method of using functions of materials are completely different. Accordingly, it would not be possible to easily achieve the present invention based on Cited Document 1.
